# EUROPEAN PATENT SPECIFICATION

(11) **EP 4 160 707 B1**
(45) Date of publication and mention of the grant of the patent: **01.07.2026**
(21) Application number: 21199906.5
(22) Date of filing: 29.09.2021
(51) Int. Cl.: H10N 30/045, B82Y 40/00

(54) **THERMAL AND ELECTROMAGNETIC GENERATION AND SWITCHING OF CHIRALITY IN FERROELECTRICS**
THERMISCHE UND ELEKTROMAGNETISCHE ERZEUGUNG UND UMSCHALTUNG DER CHIRALITÄT IN FERROELEKTRIKA
GÉNÉRATION ET COMMUTATION THERMIQUES ET ÉLECTROMAGNÉTIQUES DE LA CHIRALITÉ DANS LES MATÉRIAUX FERROÉLECTRIQUES

(43) Date of publication of application: 05.04.2023
(73) Proprietor: Terra Quantum AG, 9000 St. Gallen (CH)
(72) Inventor: Lukyanchuk, Igor, 9400 Rorschach (CH); Tikhonov, Yurii, 9400 Rorschach (CH); Razumnaya, Anna, 9400 Rorschach (CH); Vinokur, Valerii, 9400 Rorschach (CH)
(74) Representative: Lucke, Andreas

(56) References cited:
- US-A1- 2009 236 949
- LUK'YANCHUK I. ET AL: "Hopfions emerge in ferroelectrics", vol. 11, no. 1, 1 December 2020 (2020-12-01), XP055902531, Retrieved from the Internet <URL:https://www.nature.com/articles/s41467-020-16258-w.pdf> DOI: 10.1038/s41467-020-16258-w
- DAS S ET AL: "Local negative permittivity and topological phase transition in polar skyrmions", NATURE MATERIALS, vol. 20, no. 2, 12 October 2020 (2020-10-12), pages 194 - 201, XP037381951, ISSN: 1476-1122, DOI: 10.1038/S41563-020-00818-Y
- TIKHONOV YU ET AL: "Controllable skyrmion chirality in ferroelectrics", SCIENTIFIC REPORTS, 26 May 2020 (2020-05-26), England, pages 8657 - 8657, XP055904868, Retrieved from the Internet <URL:https://www.nature.com/articles/s41598-020-65291-8.pdf> [retrieved on 20220324], DOI: 10.1038/s41598-020-65291-8
- YADAV A K ET AL: "Observation of polar vortices in oxide superlattices", NATURE (LONDON), 11 February 2016 (2016-02-11), England, pages 198 - 201, XP055904870, Retrieved from the Internet <URL:https://www.nature.com/articles/nature16463.pdf> [retrieved on 20220324], DOI: 10.1038/nature16463

## Description

### TECHNICAL FIELD

The disclosure relates to techniques for generating and switching the chirality of a polarization field in a nanostructured ferroelectric.

### BACKGROUND

Chirality or handedness introduced by Lord Kelvin in 1894, is a fundamental property to describe objects without mirror symmetry. A prototypical example of chiral objects are human hands. The left hand is a non-superimposable mirror image of the right hand. The two hands do not coincide, no matter how they are oriented. Mathematically, an object is chiral (or said to have chirality) if it cannot be mapped to its mirror image by any combination of rotations and translations. The chirality distinguishes the left-handed and the right-handed modifications of the chiral object, also called enantiomers. Molecular chirality is a prime concept in stereo- and biochemistry, given that a large variety of organic substances, such as glucose, cellulose, and DNA molecules are non-mirror-symmetric. A chiral molecule is a molecule that has a non-superimposable mirror image.

Chirality is the focus of modern material science because chiral materials have exceptional laser-manipulation capabilities, such as chiral sensing, optical activity, a negative refractive index rotatory power, and circular dichroism. Due to these capabilities, chiral materials find diverse applications in optoelectronics and plasmonics. However, the fabrication of chiral nanomaterials with a tunable and switchable chirality, i. e., the design of nanoscale inorganic and hybrid objects with controllable and configurable chirality, remains a challenge. A few examples of a new generation of chiral nanomaterials include chiral metallic particles and nanocrystals, DNA-assembled plasmonic nanostructures, core-shell plasmonic spheres, and chiral plasmonic particles assembled on scaffolds. An arising problem is that chiral nanomaterials are usually fabricated as a racemic mixture of left-handed and right-handed particles with a vanishing average chiral response. But for practical applications, systems with a monochirality are highly desirable.

One way to achieve nanomaterials of a monochirality is to introduce an enantioselective synthesis. Alternative approaches filter, or sort, respectively, the nanomaterials according to their chirality after the production. Both approaches substantially complicate the industrial fabrication of the nanoparticles.

The possible ways of attacking these problems are outlined in Luk'yanchuk et al., "Hopfions emerge in ferroelectrics" Nat. Commun. 11, 2433 (2020) and in Tikhonov et al., "Controllable skyrmion chirality in ferroelectrics", Sci. Rep. 10, 8657 (2020).

US 2009/236949 A1 discloses an apparatus for producing a piezoelectric film.

### OVERVIEW

In view of the high technological demand, there is a quest for a method to create monochiral systems, making the chirality of these systems switchable and tunable. Corresponding techniques allow for manufacturing nanostructures with a desirable chirality and, most and foremost, with a controllable chirality. The control can involve switching, tuning configuring, and reconfiguring the chirality. In particular, there is a need for a method to switch the chirality of a single nanostructure reversibly and multiple times, after and independently of the fabrication of the nanostructures.

This objective is achieved with a method according to claim 1. Claim 14 refers to an apparatus for generating a nanostructured ferroelectric with a polarization state of a predefined chirality. The dependent claims relate to preferred embodiments.

Materials composed of chiral molecules find broad applications in areas ranging from nonlinear optics and spintronics to biology and pharmaceuticals. However, chirality is usually an invariable inherent property of a given material that cannot be easily changed at will. The disclosure presents a method that enables to configure, switch, and tune the chirality of nanostructured ferroelectrics to ensure their broad utilization in various applications.

In a first aspect, a nanostructured ferroelectric is adapted to provide a high-temperature state and a low-temperature ferroelectric state. In the low-temperature ferroelectric state the nanostructured ferroelectric has a polarization state from a plurality of polarization states. The plurality of polarization states comprises at least a first chiral polarization state with a first chirality, and a second chiral polarization state with a second chirality different from the first chirality. A method for generating a nanostructured ferroelectric with a predefined chirality comprises: selecting the predefined chirality from the first chirality and the second chirality; selecting an electromagnetic field according to the predefined chirality; providing the nanostructured ferroelectric in the high-temperature state; applying the electromagnetic field to the nanostructured ferroelectric in the high-temperature state; and cooling, while applying the electromagnetic field, the nanostructured ferroelectric from the high-temperature state to the low-temperature ferroelectric state to establish the polarization state of the nanostructured ferroelectric with the predefined chirality.

The polarization state of a nanostructured ferroelectric provides a switchable chirality. The switchable chiral polarization structure may, for example, be applied in storage and in sensing applications, in particular, using a polarization-dependent optical control and/or readout. The temperature variation protocol takes the nanostructure across the transition between the ferroelectric state and the high-temperature state wherein an energy barrier between the polarization states with the different chiralities is reduced. Therefore, the method can reliably drive the nanostructured ferroelectric to a polarization state with the predefined chirality using the electromagnetic field selected according to the predefined chirality.

The method may therefore provide a controllable chirality of the polarization state of the nanostructured ferroelectric. The controllable chirality may comprise a tunable, switchable, and/or reconfigurable chirality. In particular, the controllable chirality may be tunable, switchable, and/or reconfigurable multiple times and/or independent of an initial fabrication of the nanostructured ferroelectric.

As compared to methods without a thermal treatment, the disclosed method reduces the magnitude of the electromagnetic field required for a reliable switching.

The nanostructured ferroelectric may comprise lead titanate, lead zirconium titanate, zirconium oxide, zirconium hafnium oxide or hafnium oxide, in particular doped hafnium oxide, doped for example with silicon.

The nanostructured ferroelectric may comprise a multiferroic material.

According to some embodiments, any polarization state comprised in the plurality of polarization states has either the first chirality or the second chirality.

According to embodiments, a first extension of the nanostructured ferroelectric along a first direction is at most 1000 nm, in particular at most 200 nm, at most 100 nm or at most 80 nm.

A second extension of the nanostructured ferroelectric along a second direction may be at most 1000 nm, in particular at most 200 nm, at most 100 nm or at most 80 nm. In particular, the second direction may be perpendicular to the first direction.

A third extension of the nanostructured ferroelectric along a third direction may be at most 1000 nm, in particular at most 200 nm, at most 100 nm or at most 80 nm. In particular, the third direction may be perpendicular to the first direction and/or to the second direction.

The nanostructured ferroelectric may be a layer, and the first extension may correspond to a thickness of the layer.

The nanostructured ferroelectric may have a shape of a prism, and the first extension may correspond to a height of the prism.

The nanostructured ferroelectric may have a shape of a rod. The first, second, or third extension may correspond to a height of the prism. The first, second, or third extension may correspond to a width of the rod. The first, second, or third extension may correspond to a length of the rod.

In some embodiments, the nanostructured ferroelectric may have a shape of-a disc. The first or second extension may correspond to a diameter of the disc. The first or second extension may correspond to a height of the disc.

The prism may be a rectangular prism, and the second extension may correspond to a side length of a rectangular base of the rectangular prism.

In some embodiments, the nanostructured ferroelectric may have a shape of a sphere, and the first extension may correspond to a diameter of the sphere.

In other embodiments, the nanostructured ferroelectric may have a shape of a pyramid, and the first extension may correspond to a side length of the pyramid.

The high-temperature state may be a paraelectric state.

In the high-temperature state, the nanostructured ferroelectric may have an achiral polarization state.

The cooling may comprise cooling the nanostructured ferroelectric from a temperature above a Curie temperature of the nanostructured ferroelectric to a temperature below the Curie temperature of the nanostructured ferroelectric.

The low-temperature state may correspond to a room-temperature state of the nanostructured ferroelectric.

The applying the electromagnetic field may comprise irradiating the nanostructured ferroelectric with an electromagnetic wave.

The electromagnetic wave may comprise microwave, terahertz, infrared, visible, ultraviolet, or x-ray radiation.

A center wavelength of the electromagnetic wave may be at least 190 nm, in particular at least 250 nm, in particular at least 370 nm, in particular at least 700 nm.

A center wavelength of the electromagnetic wave may be at most 3000 nm, in particular at most 1400 nm, at most 1100 nm, or at most 980 nm.

The center wavelength may correspond to a weighted average of all wavelengths of the electromagnetic wave.

The electromagnetic wave may be a pulsed electromagnetic wave, in particular, with a pulse duration of at most 1 ns, in particular at most 300 ps, at most 100 ps, at most 40 ps, at most 10 ps or at most 2 ps.

According to embodiments, an energy per pulse and area of the pulsed electromagnetic wave at the nanostructured ferroelectric does not exceed 100 mJ/cm², in particular, not exceed 70 mJ/cm² or not exceed 40 mJ/cm².

Providing the nanostructured ferroelectric in the high-temperature state may comprise heating the nanostructured ferroelectric using the electromagnetic wave.

The electromagnetic wave may be elliptically polarized. A chirality of the elliptically polarized electromagnetic wave may correspond to the predefined chirality.

The electromagnetic wave may be circularly polarized. A chirality of the circularly polarized electromagnetic wave may correspond to the predefined chirality.

An elliptically or circularly polarized electromagnetic wave may provide a stimulus to make the first chiral polarization state with the first chirality energetically favorable over the second chiral polarization state with the second chirality. This enhances the probability for the nanostructured ferroelectric to develop the first chiral polarization state upon cooling to the low-temperature ferroelectric phase.

The method may further comprise supporting the nanostructured ferroelectric by a substrate, in particular while applying the electromagnetic field and/or while cooling the nanostructured ferroelectric.

The substrate may be in direct contact with the nanostructured ferroelectric and may be adapted to induce a stress or a strain in the nanostructured ferroelectric; in particular in embodiments, wherein the nanostructured ferroelectric comprises lead titanate and/or lead zirconium titanate, and/or wherein the substrate comprises strontium titanate.

The substrate may induce a strain or stress in the nanostructured ferroelectric, which may be used to tailor the chiral ground state(s) of the nanostructured ferroelectric.

In some embodiments, the substrate may be adapted to absorb heat from the nanostructured ferroelectric in the process step of cooling the nanostructured ferroelectric.

The substrate may be adapted to absorb energy from the electromagnetic wave and to provide the energy to the nanostructured ferroelectric, in the process step of providing the nanostructured ferroelectric in the high-temperature state.

In some embodiments, the substrate may be adapted to guide the electromagnetic wave, in particular to reflect the electromagnetic wave towards the nanostructured ferroelectric.

The nanostructured ferroelectric may be a ferroelectric layer arranged over the substrate.

At least one additional layer may be arranged over the nanostructured ferroelectric, in particular, at least one additional layer which is not a ferroelectric.

A second nanostructured ferroelectric may be arranged over the at least one additional layer. The second nanostructured ferroelectric may be a second ferroelectric layer.

In some embodiments, an intermediate layer may be arranged between the substrate and the ferroelectric layer, in particular a dielectric intermediate layer, for example a dielectric intermediate layer which is not a ferroelectric.

The ferroelectric layer may be comprised in a stacked multilayer structure comprising a plurality of ferroelectric layers and a plurality of additional layers. In particular, the additional layers may not be ferroelectric.

In some embodiments, the stacked multilayer structure may comprise an alternating arrangement of ferroelectric layers and additional layers.

The substrate may be adapted to transport heat to the nanostructured ferroelectric, in the process step of providing the nanostructured ferroelectric in the high-temperature state.

The nanostructured ferroelectric may be surrounded by a solid or liquid matrix while cooling the nanostructured ferroelectric.

In some embodiments, the solid or liquid matrix may be adapted to absorb heat from the nanostructured ferroelectric, in the process step of cooling the nanostructured ferroelectric.

The solid or liquid matrix may be adapted to be transparent to the electromagnetic wave.

The solid or liquid matrix may be adapted to transport heat to the nanostructured ferroelectric, in the process step of providing the nanostructured ferroelectric in the high-temperature state.

The electromagnetic field may be an inhomogeneous electromagnetic field.

The method may further comprise, during and/or after cooling the nanostructured ferroelectric from the high-temperature state to the low-temperature ferroelectric state: applying an inhomogeneous electromagnetic field to the nanostructured ferroelectric to transport the nanostructured ferroelectric to a position associated with the predefined chirality.

The applying the inhomogeneous electromagnetic field may comprise focusing an electromagnetic wave to a focal point located at, or in the proximity of the nanostructured ferroelectric.

The method may further comprise lifting the nanostructured ferroelectric off the surface using the inhomogeneous electromagnetic field.

In some embodiments, the method may further comprise applying the inhomogeneous electromagnetic field to a second nanostructured ferroelectric with a chirality different from the predefined chirality to transport the second nanostructured ferroelectric to a second position different from the position associated with the predefined chirality.

In particular, the method may comprise applying the inhomogeneous electromagnetic field to the nanostructured ferroelectric and to the second nanostructured ferroelectric at the same time to separate the nanostructured ferroelectric and the second nanostructured ferroelectric.

The substrate may be conducting, and applying the inhomogeneous electromagnetic field may induce plasmonic excitation in the substrate, in particular at the surface of the substrate. The plasmonic excitations may be adapted to separate the nanostructured ferroelectric and a second nanostructured ferroelectric with a chirality different from the predefined chirality according to the chiralities of their polarization states.

Applying the inhomogeneous electromagnetic field may comprise using optical tweezers.

In some embodiments, applying the inhomogeneous electromagnetic field may comprise using plasmonic tweezers, in particular plasmonic tweezers with a plasmonic trap stiffness in a range from 0.1 to 5 fN/(µm·W), or in a range from 0.1 to 1 fN/(µm·W).

The inhomogeneous electric field may have a field polarization, and the method may further comprise selecting the field polarization according to the predefined chirality. The field polarization may be linear, elliptical or circular.

The selecting the field polarization may comprise selecting a handedness of the circular polarization or of the elliptical polarization, or selecting a direction of the linear polarization.

The applying the electromagnetic field may comprise applying a voltage to electrodes arranged on opposite sides of the nanostructured ferroelectric.

The electrodes may be arranged on opposite sides of a plurality of nanostructured ferroelectrics comprising the nanostructured ferroelectric. In particular, the plurality of nanostructured ferroelectrics may be a racemic mixture of nanostructured ferroelectrics.

According to embodiments, exactly one nanostructured ferroelectric is arranged between the electrodes.

According to some embodiments, at least one of the electrodes has a first electrode extension along a first direction of at most 1000 nm, in particular at most 200 nm, at most 100 nm, or at most 80 nm.

According to embodiments, the at least one of the electrodes has a second electrode extension along a second direction of at most 1000 nm, in particular at most 200 nm, at most 100 nm, or at most 80 nm, wherein the second direction may be different from the first direction, in particular perpendicular to the second direction.

At least one of the electrodes may be a tip, in particular a conductive tip, in particular a tip adapted to provide a scanning tunneling microscope tip or a conductive atomic force microscope tip.

According to embodiments, an absolute value of the electric field does not exceed 100 kV/cm, in particular does not exceed 10 kV/cm.

At least one of the electrodes may have a chiral shape.

In some examples, a chiral molecule may be adsorbed on the at least one of the electrodes in the proximity of the nanostructured ferroelectric. In particular the chiral molecule may be a nanotube, for example a carbon nanotube.

The at least one of the electrodes may be a tip with a chiral distortion, in particular a conductive tip with a chiral distortion, such as a scanning tunneling microscope tip or a conductive atomic force microscope tip with a chiral distortion.

The chiral molecule on the tip, or the chiral distortion of the tip may provide a chiral electric field that may serve as a stimulus to drive the nanostructured ferroelectric into the polarization state of the predefined chirality during the cooling.

The providing the nanostructured ferroelectric in the high-temperature state may further comprise: providing the nanostructured ferroelectric in the low-temperature ferroelectric state and with the first chirality; and heating the nanostructured ferroelectric to the high-temperature state. The predefined chirality may be the second chirality.

The method according to the disclosure may provide a reversible and repeatable switching between different polarization states.

The heating the nanostructured ferroelectric to the high-temperature state may comprise using a resistive heater.

The resistive heater may be in direct contact with the nanostructured ferroelectric, or with a substrate supporting the nanostructured ferroelectric, or with a solid or liquid matrix surrounding the nanostructured ferroelectric.

The heating the nanostructured ferroelectric to the high-temperature state may comprise using a microwave heater.

The heating the nanostructured ferroelectric to the high-temperature state may use energy absorbed from the electromagnetic wave. The energy may be absorbed from the electromagnetic wave by the nanostructured ferroelectric.

Alternatively or in addition, the energy may be absorbed from the electromagnetic wave by a substrate supporting the nanostructured ferroelectric, or by a solid or liquid matrix surrounding the nanostructured ferroelectric, and the method may further comprise transporting the energy by the substrate supporting the nanostructured ferroelectric, or by the solid or liquid matrix surrounding the nanostructured ferroelectric to the nanostructured ferroelectric.

In a second aspect, an apparatus for generating a nanostructured ferroelectric with a predefined chirality comprises a retaining element, a heating element, a field application element, and a cooling element. The retaining element is adapted to receive the nanostructured ferroelectric. The heating element is adapted to heat the nanostructured ferroelectric to a high-temperature state. The field application element is adapted to apply an electromagnetic field to the nanostructured ferroelectric while the nanostructured ferroelectric is in the high-temperature state. The cooling element is adapted to cool, while applying the electromagnetic field to the nanostructured ferroelectric using the field application element, the nanostructured ferroelectric to a low-temperature ferroelectric state with a polarization state with the predefined chirality.

The nanostructured ferroelectric may be characterized by one or all of the features described above in the context of the method according to the first aspect.

The retaining element may comprise a substrate adapted to support the nanostructured ferroelectric, in particular a conductive substrate. The cooling element may comprises the substrate.

In particular, the substrate may be adapted to absorb heat from the nanostructured ferroelectric, and/or the substrate may be adapted to be in direct thermal contact with the nanostructured ferroelectric.

Alternatively, or in addition, the retaining element may comprise a solid or liquid matrix adapted to surround the nanostructured ferroelectric. The cooling element may comprise the solid or liquid matrix.

In particular, the solid or liquid matrix may be adapted to absorb heat from the nanostructured ferroelectric, and/or the solid or liquid matrix may be adapted to be in direct thermal contact with the nanostructured ferroelectric.

The heating element may comprise a resistive heater, in particular a resistive heater in direct thermal contact with the retaining element and/or a resistive heater adapted to be in direct thermal contact with the nanostructured ferroelectric.

The field application element may comprise electrodes arranged on opposite sides of the nanostructured ferroelectric.

The electrodes may be characterized by one or all the features described above in the context of the electrodes of the method according to the first aspect.

The apparatus may further comprise a monitoring element adapted to monitor the polarization state of the nanostructured ferroelectric, in particular to monitor a helicity of the polarization state of the nanostructured ferroelectric or the chirality of the polarization state of the nanostructured ferroelectric.

The monitoring element may comprise a device adapted to determine a polarization of a probe electromagnetic wave, in particular a polarimeter for a probe electromagnetic wave. The monitoring element may further comprise a probe light source adapted to generate the probe electromagnetic wave, to direct the probe electromagnetic wave to the nanostructured ferroelectric, and, after a reflection from or a transmission through the nanostructured ferroelectric, to direct the probe electromagnetic wave to the device adapted to determine the polarization of the probe electromagnetic wave.

The apparatus may further comprise a radiation source adapted to generate an electromagnetic wave, and to irradiate the nanostructured ferroelectric with the electromagnetic wave

The radiation source wave may provide the heating element and/or the field application element. The electromagnetic wave may comprise or be microwave, terahertz, infrared, or visible radiation.

The radiation source may be comprised in optical tweezers. The optical tweezers may be adapted to transport the nanostructured ferroelectric to a position associated with the predefined chirality. Alternatively or in addition, the optical tweezers may be adapted to separate the nanostructured ferroelectric from a second nanostructured ferroelectric with a chirality different from the predefined chirality.

The radiation source may be comprised in plasmonic tweezers. The plasmonic tweezers may be adapted to irradiate a conducting substrate of the nanostructured ferroelectric to induce plasmonic excitations in the conducting substrate. The plasmonic excitations in the conducting substrate may be adapted to separate the nanostructured ferroelectric and a second nanostructured ferroelectric with a chirality different from the predefined chirality. Alternatively or in addition, the plasmonic excitations in the conducting substrate may be adapted to generate plasmonic traps. The plasmonic traps may be adapted to separate the nanostructured ferroelectric and a second nanostructured ferroelectric.

The electromagnetic wave may be adapted to provide the probe electromagnetic wave.

The apparatus may further comprise focusing optics to focus the electromagnetic wave onto the nanostructured ferroelectric. In particular, the focusing optics may comprise a lens or a microscope objective.

The focusing optics and the radiation source may be adapted to generate an inhomogeneous electromagnetic field at the reception element, in particular at a position of the reception element adapted to receive the nanostructured ferroelectric. The inhomogeneous electromagnetic field may be adapted to transport the nanostructured ferroelectric to a position associated with the polarization state of the nanostructured ferroelectric, in particular to a position associated with the chirality of the polarization state of the nanostructured ferroelectric.

The focusing optics and the radiation source may provide optical tweezers adapted to move the nanostructured ferroelectric according to its polarization state, in particular according to the chirality of its polarization state.

In some embodiments, the retaining element may comprise a conductive substrate.

The radiation source and the focusing optics may be adapted to induce a plasmonic excitation in the conductive substrate, in particular at the surface of the conductive substrate.

The focusing optics, the radiation source, and the conductive substrate may provide plasmonic tweezers adapted to move the nanostructured ferroelectric according to its polarization state, in particular plasmonic tweezers with a plasmonic trap stiffness in a range from 0.1 to 5 fN/(µm·W), or in a range from 0.1 to 1 fN/(µm·W).

### BRIEF DESCRIPTION OF THE FIGURES

The techniques of the present disclosure and the advantages associated therewith will be best apparent from a description of exemplary embodiments in accordance with the accompanying drawings, in which:
- Fig. 1a: shows an illustrating example of left- and right-handed enantiomers in the form of hands;
- Fig. 1b: shows an illustrating example of left- and right-handed enantiomers in the form of helices;
- Fig. 2: shows chiral domain walls of a ferroelectric;
- Fig. 3a: shows a nanostructured ferroelectric in the form of a thin ferroelectric film with a chiral polarization state comprising skyrmions;
- Fig. 3b: shows a nanostructured ferroelectric in the form of a multilayer structure with a thin ferroelectric film having a chiral polarization state with vortices;
- Fig. 4: shows potential-energy surfaces of a nanostructured ferroelectric;
- Fig. 5: illustrates a method and an apparatus for generating a predefined chirality of a nanostructured ferroelectric according to an embodiment;
- Fig. 6a: illustrates a method and an apparatus for generating a predefined chirality of a nanostructured ferroelectric according to another embodiment;
- Fig. 6b: illustrates a method and an apparatus for generating a predefined chirality of a nanostructured ferroelectric according to another embodiment;
- Fig. 7a: illustrates a method and an apparatus for generating a predefined chirality of a nanostructured ferroelectric according to another embodiment;
- Fig. 7b: illustrates a method and an apparatus for generating a predefined chirality of a nanostructured ferroelectric according to another embodiment;
- Fig. 8: shows a nanostructured ferroelectric in the form of a nanodot with a chiral polarization structure associated with a domain wall;
- Fig. 9a: shows a nanostructured ferroelectric in the form of a nanoparticle with a chiral polarization structure without a domain wall;
- Fig. 9b: shows a nanostructured ferroelectric in the form of a nanodot with a different chiral polarization structure without a domain wall;
- Fig. 10a: illustrates a method and an apparatus for generating a predefined chirality of a nanostructured ferroelectric according to another embodiment;
- Fig. 10b: illustrates a method and an apparatus for generating a predefined chirality of a nanostructured ferroelectric according to another embodiment;
- Fig. 11a: illustrates a method and an apparatus for generating a predefined chirality of a nanostructured ferroelectric according to another embodiment;
- Fig. 11b: illustrates a method and an apparatus for generating a predefined chirality of a nanostructured ferroelectric according to another embodiment;
- Fig. 12a: illustrates a method and an apparatus for generating a predefined chirality of a nanostructured ferroelectric according to another embodiment;
- Fig. 12b: illustrates a method and an apparatus for generating a predefined chirality of a nanostructured ferroelectric according to another embodiment;
- Fig. 13: illustrates a method and an apparatus for generating a predefined chirality of a nanostructured ferroelectric using an enantioselective transport according to an embodiment; and
- Fig. 14: illustrates a method and an apparatus for generating a predefined chirality of a nanostructured ferroelectric using an enantioselective transport according to another embodiment.

### DETAILED DESCRIPTION OF EMBODIMENTS

The techniques of the present disclosure will now be described with reference to several different embodiments from the field of material science. While some features will be described only with respect to some of these embodiments, one skilled in the art will understand that these embodiments may be combined, and hence these features may generally be present in some or all of the embodiment described.

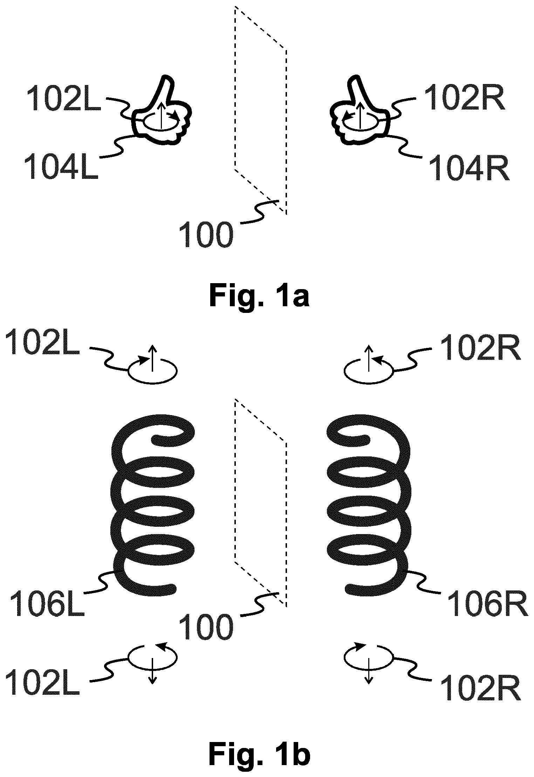

Figure 1a and 1b show two examples of chiral structures, namely human hands 104L, 104R in Figure 1a and helices 106L, 106R in Figure 1b. Both the hands 104L, 104R and the helices 106L, 106R exist as two different enantiomers. The enantiomers are mirror images of each other with respect to the mirror plane 100. The mirror image 104R, 106R differs from its prototype 104L, 106L in its sense of rotation 102R, or chirality, respectively. In this context, the enantiomer with the counter-clockwise sense of rotation 102R is referred to as the right-handed enantiomer 104R, 106R, and the enantiomer with the clockwise sense of rotation 102L is referred to as the left-handed enantiomer 104L, 106L.

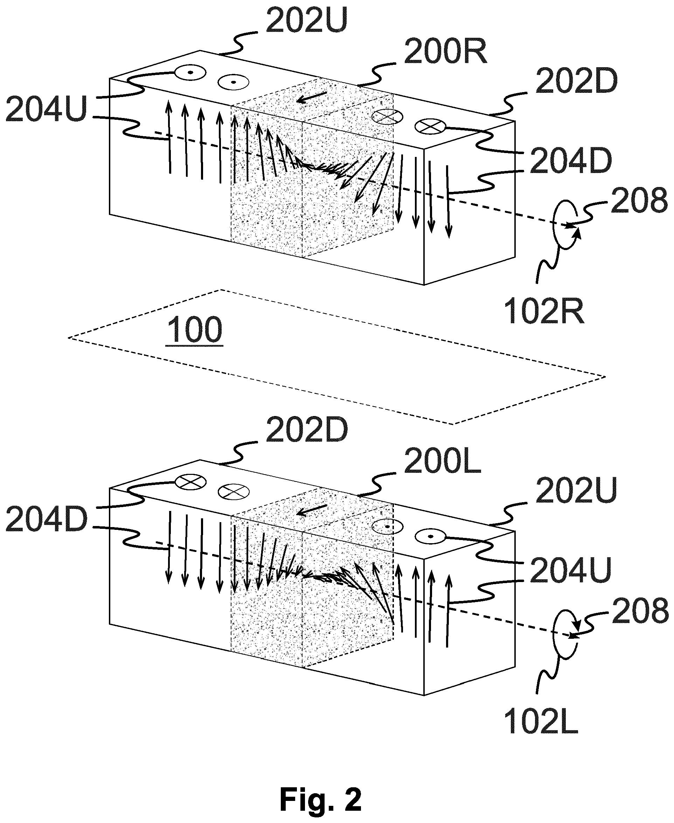

Figure 2 shows chiral ferroelectric domain walls 200L, 200R between two ferroelectric domains 202U, 202D. Ferroelectrics are characterized by a remanent polarization 204U, 204D. Long-range electric fields related to the polarization 204U, 204D are energetically costly. Therefore, bulk ferroelectrics typically exhibit domain walls 200L, 200R which reduce the long-range fields and the associated energy.

In the proximity of a domain wall 200L, 200R, the polarization 204U, 204D is typically oriented parallel to a surface defined by the domain wall 200L, 200R. Across the domain wall, the polarization was long believed to maintain its orientation and to only change its value, for example from negative to positive with respect to an axis parallel to the polarization 204U (Ising domain wall). However, recent experiments have found ferroelectric domain walls 200L, 200R with a rotation of the polarization 204U, 204D around the surface normal 208 of the domain wall 200L, 200R, as indicated in Figure 2. Domain walls of this type are referred to as Bloch domain walls 200L, 200R. The sense of the rotation 102L, 102R can be clockwise 102L or counter-clockwise 102R, resulting in a left-handed Bloch domain wall 200L or a right-handed Bloch domain wall 200R. The Bloch domain wall 202L, 202R is chiral and cannot be superimposed with itself upon mirror reflections and/or space rotation transformations.

In bulk ferroelectrics, the ferroelectric domains as well as domain walls form at random positions with random orientations. However, for many practical applications a controlled orientation and arrangement may be preferable. For this purpose, the ferroelectric is nanostructured at least along one direction.

In the context of this disclosure, a nanostructured ferroelectric may be understood to have an extension that is confined to the nanoscale, e.g. to 1 µm or less, along the at least one direction. Such a ferroelectric may also be referred to as nanoconfined.

One example is a thin layer, which is confined along the direction perpendicular to the layer.

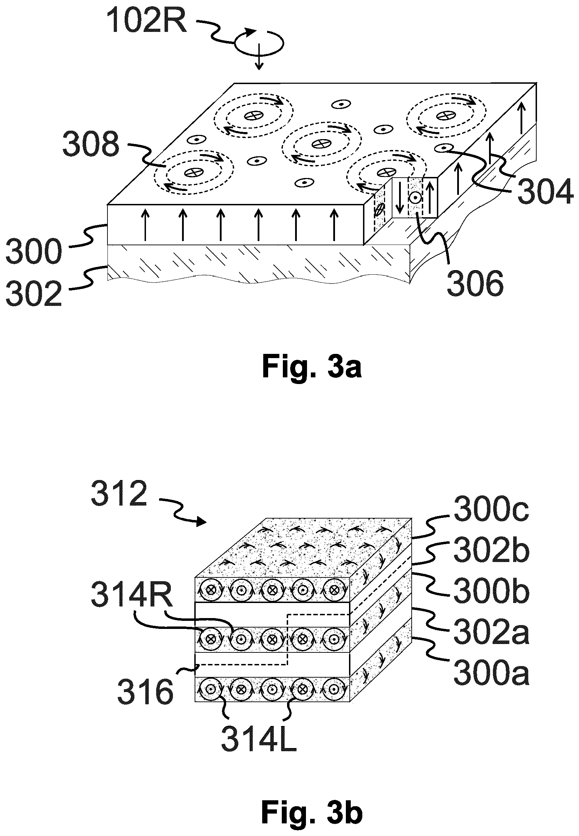

Figure 3a shows a thin ferroelectric layer 300 on a substrate 302. As a result of the nanostructured geometry, the polarization 304 is preferably oriented within (in-plane) or perpendicular (out-of-plane) to the thin ferroelectric layer 300. The choice of the ferroelectric material of the thin ferroelectric layer 300 and of the material providing its environment (e. g., the substrate 302) provides control over the orientation of the polarization 304.

The choice of the ferroelectric material of the thin ferroelectric layer 300, of the material providing its environment, e. g. the substrate, and the growth conditions, is also used to control the topology of the domain walls 306. In general, a ferroelectric thin layer may comprise chiral (e. g., Ising) and achiral domain walls like the Bloch domain walls described in the context of Figure 2.

For a layer comprising various kinds of chiral and achiral domain walls, the chirality may be defined as the sign of the helicity *H* = ∫ *̅P̅*̅(∇̅ × *̅P̅*̅)*d*³*r*, where *̅P̅*̅ denotes the polarization, and the integration is carried out over the volume of the nanostructured ferroelectric, for example the thin ferroelectric layer 300.

Figure 3a depicts a thin ferroelectric layer 300 of lead titanate (PbTiO₃) deposited with a thickness of 50 nm over a dielectric strontium titanate (SrTiO₃) substrate 302. The lattice mismatch induces a strain in the ferroelectric layer 300. The thin ferroelectric layer 300 develops an out-of-plane orientation of the polarization 304.

The ferroelectric thin layer was grown using pulsed laser deposition, but physical vapor deposition techniques, atomic layer deposition or molecular beam epitaxy may alternatively be applied. Details of the growth conditions can be found in Das et al., "Local negative permittivity and topological phase transition in polar skyrmions", Nat. Mater. 20, 194 (2021).

The growth conditions of the ferroelectric layer 300 of Figure 3a are optimized for the polarization 304 to form a chiral polarization state with skyrmions 308. The skyrmions can be viewed as Bloch domain walls similar to one of the Bloch domain walls 200L, 200R described above in the context of Figure 2.

However, the skyrmion 308 has a curvature resulting in a self-closed structure 308. According to the chirality of the underlying Bloch domain wall, the skyrmion 308 can be left-handed or right-handed. Figure 3a illustrates a skyrmion 308 with a counter-clockwise sense of rotation 102R, i. e. a right-handed skyrmion 308. A regular arrangement of skyrmions 308 as depicted in Figure 3a is sometimes also referred to as a chiral bubble domain, or as a cylindrical domain.

Figure 3b shows a multilayer structure 312, containing an alternative sequence of thin ferroelectric layers 300a, 300b, 300c and paraelectric layers 302a, 303b. For example, the multilayer structure may be formed from alternating layers of the ferroelectric lead titanate and the dielectric strontium titanate, each with a thickness of 9 to 10 nm, as described in detail in Yadav et al., "Observation of polar vortices in oxide superlattices," Nature 530, 198 (2016). The same growth techniques as described in the context of the thin ferroelectric layer 300 of figure 3a are applied to form the ferroelectric layers.

The multilayer structure 312 of Figure 3b comprises three thin ferroelectric layers 300a, 300b, 300c and two paraelectric layers 302a, 302b, but this is a mere example, and the number of layers may generally be freely adapted to the requirements of the application. For example, for an optical application, the number of ferroelectric layers may be increased to at least 10 or at least 50 or at least 100 to generate a multilayer structure 312 with an enhanced thickness and optical activity. In contrast, for a storage application a single ferroelectric layer may be used to minimize the amount of polarized material and to maximize the switching speed.

The polarization of the thin ferroelectric layers 300a, 300b, 300c of the multilayer structure 312 forms coreless vortices 314L, 314R. The coreless vortices 314L, 314R within each of the thin ferroelectric layers 300a, 300b, 300c typically swirl alternatively in opposite directions. The chirality of the vortices 314L, 314R emerges in cases where the vortices have the coreless structure and polarization escapes in the third space direction along the vortex axis, forming helical chiral texture. The dashed line 316 separates a region with the left-handed vortices 314L from a region with right-handed vortices 314R.

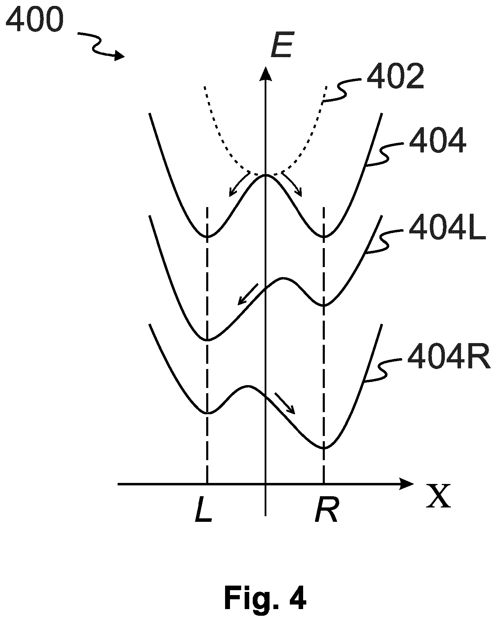

Any of the chiral structures of the nanostructured ferroelectrics, such as the Bloch domain walls 200L, 200R, the skyrmions 308, or the vortices 314L, 314R can be either right-handed or left-handed, and the polarization states associated with both chiralities are typically energetically degenerate. As a consequence, both chiralities may have an equal probability to form when cooling the nanostructure ferroelectric from a paraelectric high-temperature state to the ferroelectric room-temperature state. The equal probabilities for either handedness to form may be understood as an immediate consequence of the energetic degeneracy of the two states. However, the situation may change when a suitable external stimulus is applied, as will now be described in further detail with reference to Figure 4.

Figure 4 depicts the energy E of the polarization states of the nanostructured ferroelectrics as a function of their chirality χ. Figure 4 shows the potential-energy landscape 402 (dashed line) for the high-temperature paraelectric state, the potential-energy landscape 404 for the ferroelectric state in the absence of an external stimulus, and the potential-energy landscapes 404L, 404R for the ferroelectric state in the presence of two different external stimuli.

When cooling through the Curie temperature in the absence of an external stimulus, the polarization state may have the same probability to transition from the potential-energy surface 402 of the paraelectric state to the energetic minima of the potential-energy surface 404 of the ferroelectric state associated with a left-handed chirality *L* and with the right-handed chirality *R*. However, application of a suitable stimulus may lift the energetic degeneracy of the minima associated with the two chiralities *L, R.* One handedness, or chirality may become preferred by the ferroelectric. In Figure 4, this is reflected in the lower energy of the minimum associated with the left-handed chirality *L* in the potential-energy landscape 404L in the presence of the external stimulus.

A modified external stimulus may result in a potential-energy landscape 404R with a lower-energy minimum for the right-handed chirality *R*. Thus, if the ferroelectric is cooled from the high-temperature paraelectric state 402 to the low-temperature ferroelectric state in the presence of either of the two stimuli, it may attain the state at the corresponding energy minimum of the potential-energy surface 404L, 404R with a defined chirality *L, R.*

The stimulus may comprise electromagnetic radiation, an electrical field, mechanical forces, a structural or a chemical stimulus. An aspect of the present disclosure concerns the design of a suitable stimulus, and of a method and an apparatus for applying that stimulus.

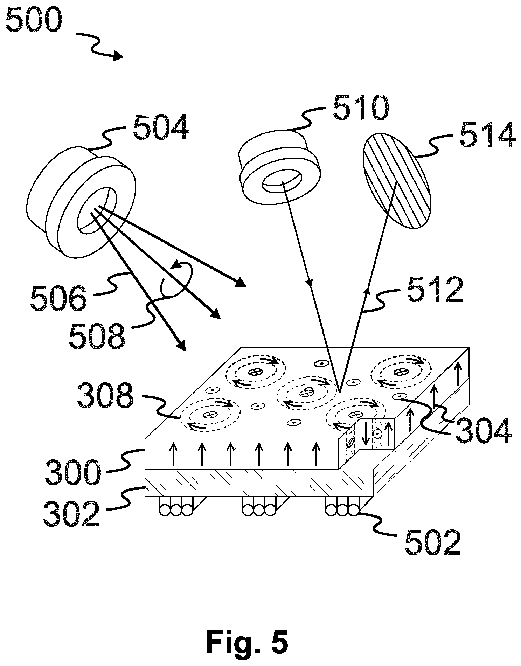

Figure 5 illustrates a photo-assisted method and an apparatus for generating a desirable chirality and switching of chirality of a nanostructured ferroelectric according to a first embodiment. According to the embodiment of Figure 5, the chirality of a thin ferroelectric layer 300 on a substrate 302, which may be similar to the thin ferroelectric layer 300 on the substrate 302 of Figure 3a, is controlled. However, the method may also be applied to other nanostructured ferroelectrics, for example to a multilayer structure such as the multilayer structure 312 of Figure 3b.

The apparatus includes a resistive heater 502 in thermal contact with the substrate 302. Applying a supply voltage to the heater 502, the temperature of the heater 502, the substrate 302 and the thin ferroelectric layer 300 is increased until the temperature of the ferroelectric layer 300 approaches or exceeds the Curie temperature of the ferroelectric material comprised therein, for example 400°C for BaTiO₃ or 500°C for PbTiO₃. Upon the heating, the ferroelectric material may undergo a phase transition from the room-temperature ferroelectric phase to a high-temperature paraelectric phase.

Thereafter, the power supplied to the heater 502 is reduced, and the thin ferroelectric layer 300 is cooled from the paraelectric high-temperature phase to a temperature well below the Curie temperature of the ferroelectric material comprised in the thin ferroelectric layer 300. Radiative heat transfer from the surface of the thin ferroelectric layer 300 to the environment typically provides a sufficient heat transfer for cooling. However, for thick layers 300 and/or substrates 302, the substrate 302 may be coupled to a cooling device, such as a Peltier element, to remove heat from the thin ferroelectric layer 300 faster.

Upon cooling to a temperature below the Curie temperature, the paraelectric phase may become unstable, and a symmetry breaking of the local polarization may occur, resulting in a local formation of a remanent polarization 304 in the thin ferroelectric layer 300. The thin ferroelectric layer 300 may attain a polarization structure with an out-of-plane polarization 304 as depicted in Figure 5 and in Figure 3a. To minimize the energy associated with the out-of-plane polarization 304, skyrmions 308 surrounding small regions (cores) of opposite polarization may form in addition. The skyrmions 308 may be right-handed or left-handed. As discussed in the context of Figure 4 for an arbitrary nanostructured ferroelectric, skyrmions 308 of either handedness, or chirality, respectively, may have equal energies and therefore an equal probability to form during cooling in the absence of an external stimulus.

According to the embodiment depicted in Figure 5, a laser 504 irradiates the thin ferroelectric layer 300 with light or near-infrared radiation 506 with a circular polarization 508. It thus provides the external stimulus to break the energetic degeneracy between the polarization states 304 with left-handed and right-handed skyrmions 308. Depending on the handedness of the circular polarization 508, or the chirality of the light or near-infrared radiation 506, respectively, a polarization state with left-handed skyrmions 308 or with right-handed skyrmions 308 becomes the global energetic minimum and forms during the cooling. The emitting light or near-infrared radiation 506 is applied while cooling the thin ferroelectric layer 300 from the high-temperature paraelectric state to a temperature well below the Curie temperature. As the nanostructured ferroelectric 300 is cooled, its polarization state may attain the global minimum of the potential energy surface 504L, 504R with left-handed or right-handed chirality, where the chirality is controlled via the helicity of the light or near-infrared radiation 506. This way, the polarization state with left-handed or right-handed skyrmions 308 may be prepared in a controlled manner. By repeating the process steps of heating, applying the light or near-infrared radiation 506 of a selected helicity, and cooling, polarization states with controlled chiralities may be rewritten repeatedly.

The embodiment depicted in Figure 5 uses a laser 504 as a source of light or near-infrared radiation 506, more specifically a Ti:sapphire amplifier system which emits laser pulses in a wavelength range from 700 to 1200 nm at a repetition rate of 1 kHz. The emitted laser pulses may be frequency-doubled, -tripled or -quadrupled. Laser pulses may also be provided by a laser amplifier using a doped fiber. The excitation laser fluence may be selected below 40-70 mJ cm⁻² to avoid damage to the nanostructured ferroelectric 300. According to alternative embodiments, terahertz radiation emitted from a quantum cascade laser, microwave radiation from a magnetron, or x-ray radiation from an x-ray tube or a synchrotron may be applied.

According to the embodiment depicted in Figure 5, the energy for heating the nanostructured ferroelectric 300 is provided mainly by the resistive heater 502. Alternatively, the laser 504, or an alternative radiation source 504 as described above may provide a significant fraction of the energy for the heating, or even all of it and a resistive heater may be omitted. The energy from the laser or radiation source 504 may be absorbed directly by the nanostructured ferroelectric 300, or may be absorbed by the substrate and subsequently be transported towards the nanostructured ferroelectric 300 by the substrate 302.

The apparatus 500 of Figure 5 comprises an additional laser 510 acting as a probe light source emitting probe light 512. Part of the probe light 512 is reflected from the surface of the thin ferroelectric layer 300, and another part of the probe light 512 is transmitted through the thin ferroelectric layer 300 and reflected from the substrate 302 before being transmitted through the thin ferroelectric layer 300 again. The polarization of reflected and/or transmitted probe light 512 may be analyzed using a rotatable polarizer 514 acting as a polarimeter together with a photodetector (not shown). The measurement of the polarization of the reflected and/or transmitted probe light 512 may permit to monitor the polarization, and in particular the chirality, of the nanostructured ferroelectric. Alternatively to using an additional laser 510 for the probe light source, part of the light or near-infrared radiation 506 from the laser 504 may be used for monitoring the polarization state.

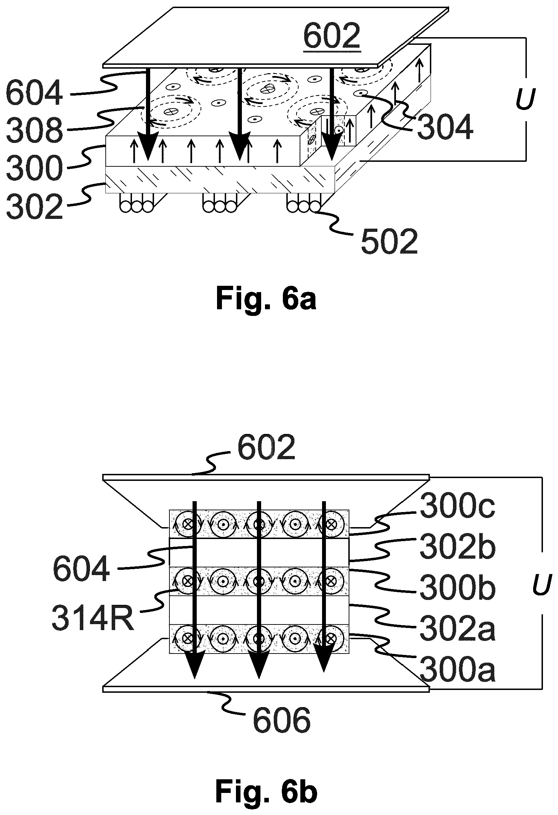

Figure 6a illustrates a method and an apparatus for generating a desirable chirality of a nanostructured ferroelectric according to a second embodiment. The apparatus comprises a heater 502, which may be similar to the heater 502 described in the context of the embodiment of Figure 5. In addition, a counter electrode 602 is provided on a side of the thin ferroelectric layer 300 opposite to the substrate 302. Applying a supply power to the heater 502, the thin ferroelectric layer 300 may be heated to a temperature close to or above the Curie temperature of the ferroelectric material comprised in the thin ferroelectric layer 300. During the subsequent cooling of the thin ferroelectric layer 300, a voltage U is applied between the substrate 302 and the counter electrode 602 to generate an electric field 604 through the thin ferroelectric layer 300. The electric field 604 may lift the energetic degeneracy between the local minima in the potential energy surface 404 of the thin ferroelectric layer 300. The amplitude of the electric field 604 may be up to 10 kV/cm or, depending on the ferroelectric material and its thickness, even up to 100 kV/cm. Depending on the sign of the voltage U, or the direction of the electric field 604, respectively, a potential energy surface 404L with a global minimum for a left-handed chirality *L* of the thin ferroelectric layer or a potential energy surface 404R with a global minimum for a right-handed chirality *R* of the thin ferroelectric layer may be generated. Cooling the thin ferroelectric layer 300 in the presence of the electric field 604 may thus prepare the ferroelectric layer 300 with skyrmions 308 of a controlled chirality, either left-handed or right-handed.

Figure 6b illustrates an embodiment similar to the one of Figure 6a. However, instead of a single counter electrode, a top electrode 602 and a bottom electrode 606 are provided. A voltage U is applied between the top electrode 602 and the bottom electrode 606 to generate the electric field 604. This way, the electric field 604 may be applied to the nanostructured ferroelectric 300a, 300b, 300c in the absence of a conductive substrate.

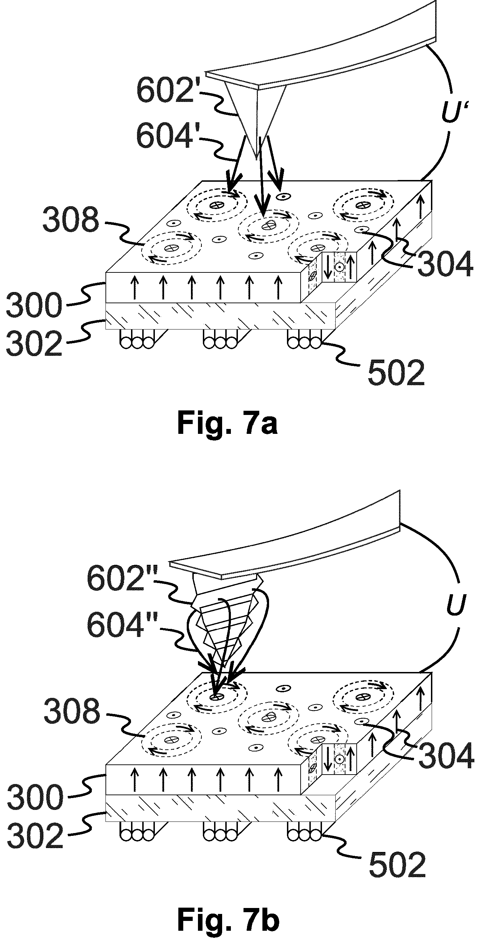

Figure 7a illustrates a method and an apparatus for generating a desirable chirality and switching of chirality of a nanostructured ferroelectric 300 according to a third embodiment. The embodiment is similar to the one described in the context of Figure 6a. However, a conductive atomic force microscopy tip 602' is used as a counter electrode to achieve a strongly localized electric field 604'. This may offer two advantages: Firstly, due to the tip enhancement of the electric field 604', a reduced voltage U' is sufficient to provide a large enough electric field 604' to reliably control the chirality of the polarization state 304 of the thin ferroelectric layer 300. Secondly, the electric field 604' is spatially confined on the nanometer scale, thus providing the possibility to write chiral structures 308 with nanometer-sized dimensions into the thin ferroelectric layer 300. This is particularly attractive for the generation of (optical) metamaterials or for storage applications.

Figure 7b illustrates an embodiment similar to the one of Figure 7a, but with the difference that the conductive atomic force microscopy tip 602" is chiral, and thus produces a chiral electric field 604". The right-handed chiral electric field 604" of Figure 7b further reduces the energy 404R of the right-handed chiral polarization state of the skyrmions 308 of the thin ferroelectric layer 300, and thus supports the formation of right-handed skyrmions 308 when the thin ferroelectric layer 300 is cooled to the ferroelectric phase. The conductive atomic force microscopy tip 602" may be produced prior to the usage in the scanning probe microscopy, for example by growing or etching the tip 602' with an overall chiral shape or by applying a torque to an initially achiral tip 602'. Alternatively, the conductive atomic force microscopy tip 602" may have a widely achiral shape, and a chiral molecule, such as a chiral carbon nanotube, may be adsorbated at the very tip, for example by picking it up in the scanning process of the scanning probe microscopy. Reservoirs of left-handed and right-handed chiral molecules may be provided in different regions on the substrate 302, and the chirality of the tip 604" may be altered by picking up a chiral molecule from the corresponding region.

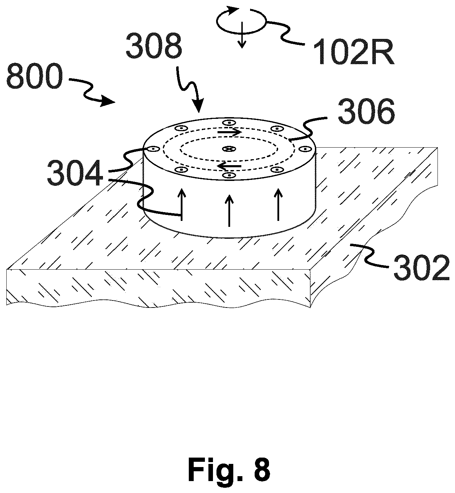

Figure 8 shows a cylindrical nanodot 800 hosting a skyrmion 308 on a substrate 302. The skyrmion 308 may be illustrated as a curved and self-closing domain wall 306, as described previously in the context of Figure 3a. The sense of rotation 102R of the skyrmion 308 of Figure 8 is right-handed. Compared to the ferroelectric in the thin ferroelectric film 300, the ferroelectric in the nanodot 800 is subject to an additional confinement along both directions parallel to the surfaces of the substrate 302, the thin ferroelectric film 300 and/or the nanodot 800. The additional confinement may improve the control over the formation, the location, and the sense of rotation of the skyrmion 308, while the control via the environment, in particular via the choice of the substrate 302, is still possible.

The nanodot 800 has a diameter of 60 nm and a height of 30 nm. It may be produced by depositing bismuth ferrite on strontium titanate on a porous anodic alumina scaffold, as described in detail in Li et al., "High-density array of ferroelectric nanodots with robust and reversibly switchable topological domain states," Sci. Adv. 3, e1700919 (2017). Alternatively, the nanodot 800 may be produced by first depositing a continuous film of the ferroelectric on a flat substrate and subsequently structuring the continuous film using lithography (e. g. photolithography, electron beam lithography, ion beam lithography, x-ray lithography) and etching techniques (e. g. wet etching, ion beam etching, reactive-ion etching). The nanodot 800 of Figure 8 is cylindrical, i. e., a prism with a circular basis. Using the lithographic fabrication techniques, nanodots with a prism shape and a wide range of shapes of the basis can be produced, giving the option to optimize the shape and size of the nanodots 800 according to the requirements of the specific application. For example, the basis may be rectangular and strongly elongated (nanorod), square, triangular, or elliptical. The methods and an apparatus for generating a desirable chirality of a nanostructured ferroelectric according to the disclosure are applicable to nanodots with any of those shapes.

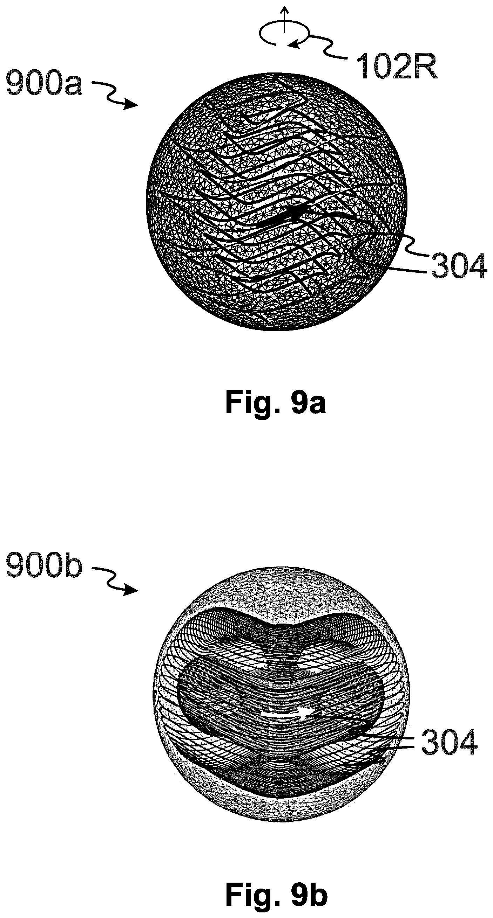

Figures 9a and 9b show nanoparticles 900a, 900b. Within the context of this disclosure, a nanodot 800 may have a polarization structure with a chirality that depends on the presence of a domain wall 306, whereas nanoparticles 900a, 900b may have a polarization state with a chirality even in the absence of a domain wall.

The nanoparticles 900a, 900b depicted in Figures 9a and 9b are spherical, with a diameter of 30 nm. The nanoparticles may be fabricated using solvothermal and hydrothermal methods. Alternatively, the nanoparticles 900a, 900b may be produced using sol-gel synthesis, peroxo-oxalate complexation methods, non-isothermal decomposition, or by any combination of these techniques. The size and the shape may be tuned via the choice of the ferroelectric material and the preparation conditions. For example, a faceted, overall approximately spherical shape, a pyramidal, cubic, cuboid, icosahedral, or dodecahedral shape may be achieved. The nanoparticle may also have one of the shapes described in the context of the nanodot 800.

Figures 9a and 9b give two examples of nanoparticles 900a, 900b with polarization states 304 that exhibit chirality. The polarization state of the nanoparticle 900a, 900b may depend on the preparation conditions and/or on a previous treatment with an external stimulus, such as an external electrical field. Preparation conditions and external-field treatment may be tuned to achieve, for example, a vortex state, a Hopfion, or a skyrmion state. Details are given in Luk'yanchuk et al., "Hopfions emerge in ferroelectrics," Nat. Commun. 11, 2433 (2020).

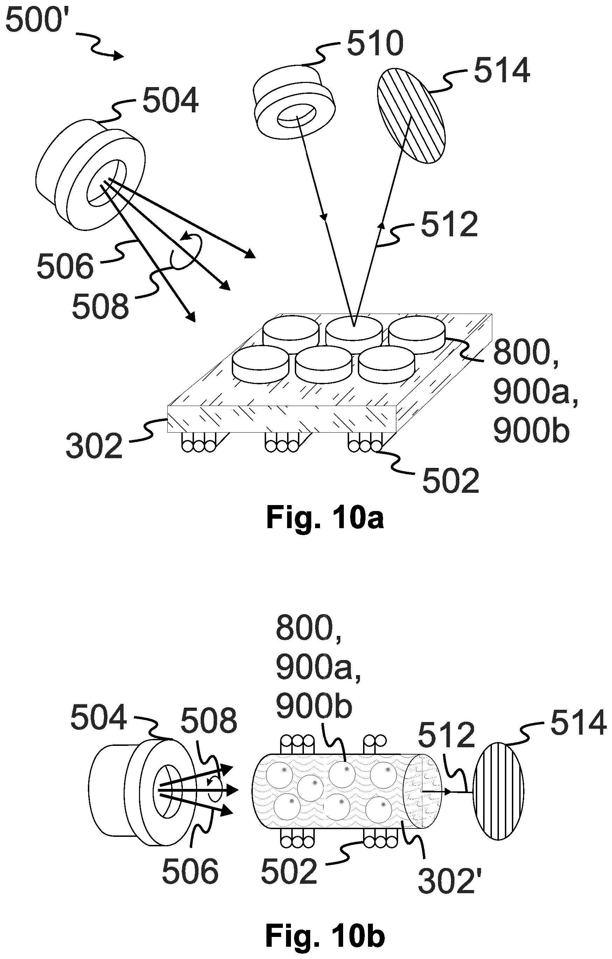

The methods and an apparatus for generating a desirable chirality of a nanostructured ferroelectric described in Figures 4, 5, 6a, 6b, 7a and 7b may also be applied to the nanodots 800 and the nanoparticles 900a, 900b as nanostructured ferroelectrics to generate a desirable chirality. The disclosure related to Figures 10a, 10b, 11a, 11b, 12a, and 12b refers to the corresponding parts of the disclosure above, and similar components will not be described again. Only aspects of the methods and apparatus related to the specific application to the nanodots 800 and the nanoparticles 900a, 900b will be pointed out.

Figure 10a illustrates a photo-assisted method and an apparatus 500' for generating a desirable chirality and switching of chirality of nanodots 800 or nanoparticles 900a, 900b similar to the embodiment described in the context of Figure 5 for a thin ferroelectric film. Nanodots 800 with a cylindrical shape are depicted in Figure 10a, but the method may be applied to any of the nanodots 800 or nanoparticles 900a, 900b described above in the context of Figures 8, 9a and 9b.

Figure 10b illustrates an embodiment similar to the one of Figure 10a. In this embodiment, the nanodots 800 or nanoparticles 900a, 900b are embedded in a solid or liquid matrix 302' rather than supported on a substrate 302. Surrounding the nanodots 800 or nanoparticles 900a, 900b by the solid or liquid matrix 302' may provide a highly efficient pathway for transporting heat away from the nanodots 800 or nanoparticles 900a, 900b, and thus to cool them effciently. Therefore, the material forming the solid or liquid matrix 302' may be selected to provide an optimized heat conductivity. According to the embodiment, part of the light or near-infrared radiation 506 from the laser 504 may be used for the polarimeter 514 monitoring the polarization state of the nanodots 800 or nanoparticles 900a, 900b. However, an additional probe light source may be provided, for example to irradiate the nanodots 800 or nanoparticles 900a, 900b along a direction perpendicular to the one of the light or near-infrared radiation 506.

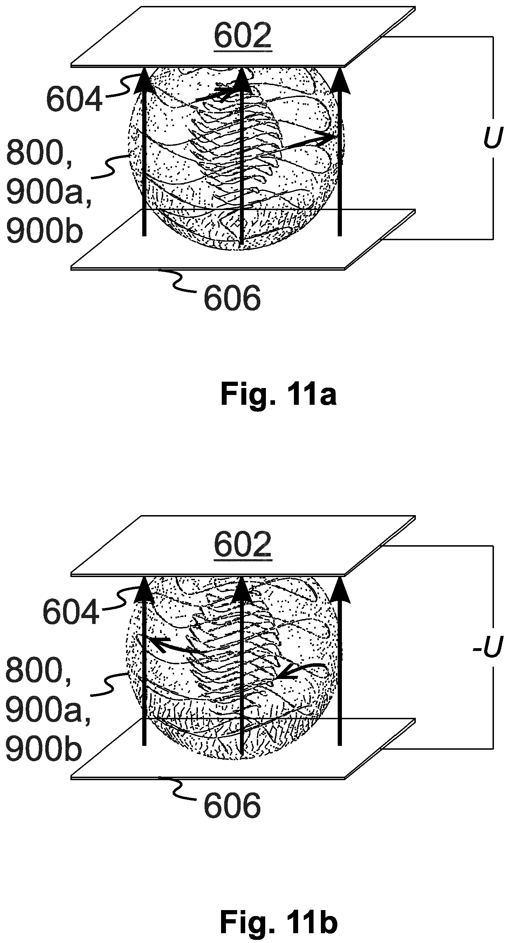

Figures 11a and 11b illustrate an embodiment similar to the one of Figure 6b. A top electrode 602 and a bottom electrode 606 are arranged on opposite sides of a nanodot 800 or nanoparticle 900a, 900b. Applying a voltage U between the electrodes 602, 606 generates an electric field 604, which may serve as a stimulus to generate the polarization state with the desirable chirality while cooling the nanodot 800 or nanoparticle 900a, 900b. In Figure 11b, the voltage -U applied between the top electrode 602 and the bottom electrode 606 is reversed as compared to the voltage U applied in Figure 11a, resulting in a reversed chirality of the polarization state of the nanodot 800 or nanoparticle 900a, 900b.

According to an embodiment, the bottom electrode 606 is provided by a conductive substrate.

According to an embodiment, the nanodot 800 or nanoparticle 900a, 900b may be deposited on the bottom electrode from a suspension or solution by dip-coating or spin-coating. The concentration of the nanodots 800 or nanoparticles 900a, 900b in the suspension or solution may be selected to control the density of deposited nanodots 800 or nanoparticles 900a, 900b per area on the bottom electrode 606. In particular, the concentration may be selected to achieve a sufficiently low density to have a single nanodot 800 or nanoparticle 900a, 900b in the electric field 604 if required by the application. Other applications may require a larger number of nanodots 800 or nanoparticles 900a, 900b in the field, which can readily be achieved by applying a suspension or solution with a high concentration of nanodots 800 or nanoparticles 900a. The top electrode may be deposited over the deposited nanodot 800 or nanoparticle 900a, 900b. Prior to depositing the top electrode, a matrix, in particular a dielectric matrix, may be deposited around the nanodot 800 or nanoparticle 900a, 900b, in particular to provide a propagation pathway for electromagnetic radiation to heat the nanodot 800 or nanoparticle 900a, 900b. The matrix may be optimized for high heat conductance to promote cooling of the nanodot 800 or nanoparticle 900a, 900b.

In an alternative embodiment, the electrodes 602, 606 may be arranged in a single plane, for example as finger structures on a surface. The nanodots 800 or nanoparticles 900a, 900b may be deposited between the electrodes 602, 606 from a suspension or a solution. The density of the deposited nanodots 800 or nanoparticles 900a, 900b may be controlled via the concentration of the suspension or solution, as described above. Any or both of the electrodes 602, 606 may also serve as a resistive heater to heat the nanodots 800 or nanoparticles 900a, 900b.

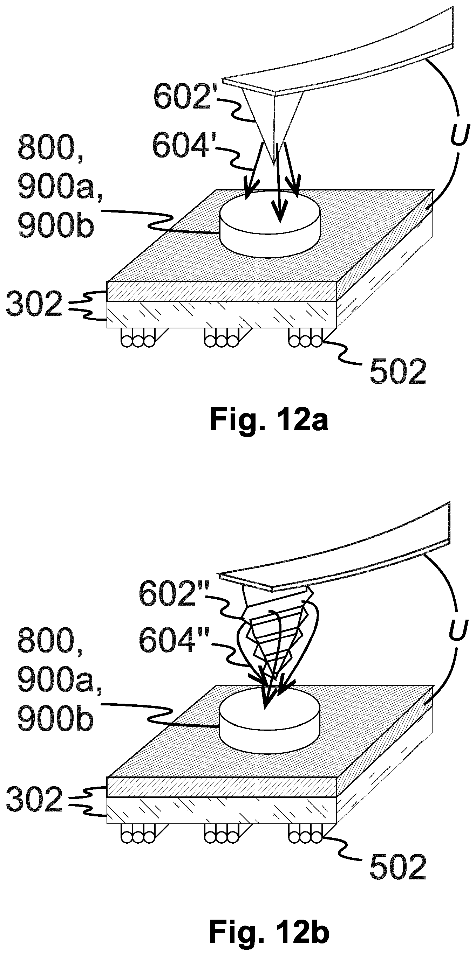

Figure 12a shows an embodiment similar to the one of Figure 7a. Using a tip 602' as the top electrode, the electric field 604' may be selectively applied to an individual nanodot 800 or nanoparticle 900a, 900b of a plurality of nanodots 800 or nanoparticles 900a, 900b present on the substrate 302.

Figure 12b shows an embodiment similar to the one of Figure 7b. Using a chiral tip 602" as the top electrode, the electric field 604" may be selectively applied to an individual nanodot 800 or nanoparticle 900a, 900b of a plurality of nanodots 800 or nanoparticles 900a, 900b present on the substrate 302.

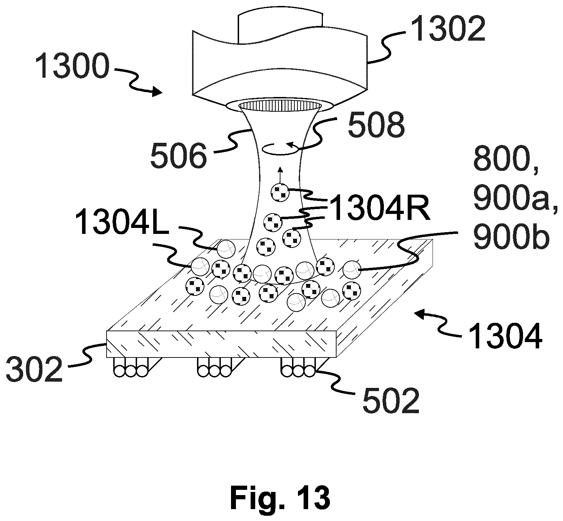

Figure 13 shows an embodiment using an enantioselective transport of nanodots 800 or nanoparticles 900a, 900b from an ensemble 1304 of nanodots 800 or nanoparticles 900a, 900b. The ensemble 1304 may contain both left-handed nanodots or nanoparticles 1304L and right-handed nanodots or nanoparticles 1304R. The optical tweezers 1300 consist of a light source (not shown) to produce light or near-infrared radiation 506 with a circular polarization 508, and a microscope objective 1302 to tightly focus the light or near-infrared radiation 506. The tight focusing may generate gradients of the light or near-infrared radiation 506, resulting in a force on the nanodots 800 or nanoparticles 900a, 900b of the ensemble 1304. The force on the nanodots 800 or nanoparticles 900a, 900b may depend on the chirality of the nanodots 800 or nanoparticles 900a, 900b, and on the circular polarization 508 of the light or near-infrared radiation 506. The circular polarization 508 may be selected to selectively transport nanodots 800 or nanoparticles 900a, 900b of a pre-selected chirality. In the example shown in Figure 13, the light or near-infrared radiation 506 with right-handed circular polarization 508 transports only those nanodots 800 or nanoparticles 1304R of the ensemble 1304 which have a right-handed chirality.

In the method according to the embodiment of Figure 13, the light or near-infrared radiation 506 heats the ensemble 1304 of nanodots 800 or nanoparticles 900a, 900b to a paraelectric state. Alternatively or in addition, the ensemble 1304 may be heated using a resistive heater 502 in thermal contact with the substrate 302. The heating power may subsequently be reduced, and the ensemble 1304 may cool down. The selected circular polarization 508 may determine the generated chirality of the polarization state of the nanodots 800 or nanoparticles 900a, 900b. When the nanodots 800 or nanoparticles 900a, 900b have cooled to the ferroelectric state and have attained the preselected chirality, the enantioselective transport may be applied to either move nanodots 800 or nanoparticles 900a, 900b of the predetermined chirality to a target destination, or to remove nanodots 800 or nanoparticles 900a, 900b of the opposite chirality. This way, the purity of the chirality of an ensemble 1304 of nanodots 800 or nanoparticles 900a, 900b may be further improved.

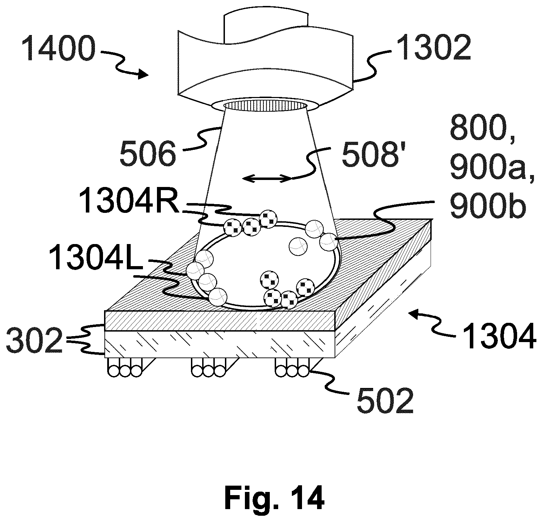

Fig. 14 shows another embodiment using an enantioselective transport of nanodots 800 or nanoparticles 900a, 900b from an ensemble 1304 of nanodots 800 or nanoparticles 900a, 900b. The embodiment is similar to the one of Figure 13. However instead of optical tweezers 1300, plasmonic tweezers 1400 are applied. Therefore, light or near-infrared radiation 506 with a linear polarization 508' is focused onto a conductive substrate 302 using the microscope objective 1302. The linearly polarized light or near-infrared radiation 506 may induce a plasmonic excitation in the conductive substrate 302, which may exert a force on to the ensemble 1304 of nanodots 800 or nanoparticles 900a, 900b. The typical plasmonic trap stiffness can vary from 0.1 to 1 and to 5 fN/(µm*mW). The force experienced by a nanodot 800 or nanoparticle 900a may differ for a left-handed nanodot or nanoparticle 1304L and a right-handed nanodot or nanoparticle 1304R. Therefore, left-handed nanodots or nanoparticles 1304L and right-handed nanodots or nanoparticles 1304R may be transported to different regions on the surface 302, and may thereby be separated.

The description of the embodiments and the figures merely serves to illustrate the techniques of the present disclosure and the advantages associated therewith, but should not be construed to imply any limitation. The scope of the disclosure is to be determined from the appended claims.

## Claims

1. A method for generating a nanostructured ferroelectric (300, 300a, 300b, 300c, 800, 900a, 900b) with a predefined chirality,
wherein the nanostructured ferroelectric (300, 300a, 300b, 300c, 800, 900a, 900b) is adapted to provide a high-temperature state and a low-temperature ferroelectric state;
wherein in the low-temperature ferroelectric state the nanostructured ferroelectric (300, 300a, 300b, 300c, 800, 900a, 900b) has a polarization state from a plurality of polarization states;
wherein the plurality of polarization states comprises at least a first chiral polarization state with a first chirality (102R) and a second chiral polarization state with a second chirality (102L) different from the first chirality (102R);
the method comprising:
selecting the predefined chirality from the first chirality (102R) and the second chirality (102L);
selecting an electromagnetic field (506, 604, 604', 604") according to the predefined chirality;
providing the nanostructured ferroelectric (300, 300a, 300b, 300c, 800, 900a, 900b) in the high-temperature state, wherein the high-temperature state is a paraelectric state or a ferroelectric state different from the low-temperature ferroelectric state at an elevated temperature;
applying the electromagnetic field (506, 604, 604', 604") to the nanostructured ferroelectric (300, 300a, 300b, 300c, 800, 900a, 900b) in the high-temperature state; and
cooling, while applying the electromagnetic field (506, 604, 604', 604"), the nanostructured ferroelectric (300, 300a, 300b, 300c, 800, 900a, 900b) from the high-temperature state to the low-temperature ferroelectric state to establish the polarization state of the nanostructured ferroelectric (300, 300a, 300b, 300c, 800, 900a, 900b) with the predefined chirality.

2. The method according to claim 1, wherein a first extension of the nanostructured ferroelectric (300, 300a, 300b, 300c, 800, 900a, 900b) along a first direction is at most 1000 nm, in particular at most 200 nm, at most 100 nm or at most 80 nm.

3. The method according to claim 1 or 2, wherein the high-temperature state is a photo-induced excited state and/or an irradiation-induced excited state.

4. The method according to any of the preceding claims, wherein the low-temperature state corresponds to a room-temperature state of the nanostructured ferroelectric (300, 300a, 300b, 300c, 800, 900a, 900b).

5. The method according to any of the preceding claims, wherein the applying the electromagnetic field (506) comprises irradiating the nanostructured ferroelectric (300, 300a, 300b, 300c, 800, 900a, 900b) with an electromagnetic wave (506).

6. The method according to claim 5, wherein the electromagnetic (506) wave is elliptically polarized; in particular, wherein a chirality (508) of the elliptically polarized electromagnetic wave (506) corresponds to the predefined chirality.

7. The method according to any of the preceding claims, further comprising supporting the nanostructured ferroelectric (300, 300a, 300b, 300c, 800, 900a, 900b) by a substrate (302), in particular while applying the electromagnetic field (506, 604, 604', 604").

8. The method according to any of the preceding claims, wherein the nanostructured ferroelectric (300, 300a, 300b, 300c, 800, 900a, 900b) is surrounded by a solid or liquid matrix (302') while cooling the nanostructured ferroelectric (300, 300a, 300b, 300c, 800, 900a, 900b).

9. The method according to any of the preceding claims, further comprising, during and/or after cooling the nanostructured ferroelectric (300, 300a, 300b, 300c, 800, 900a, 900b) from the high-temperature state to the low-temperature ferroelectric state:
applying an inhomogeneous electromagnetic field to the nanostructured ferroelectric (300, 300a, 300b, 300c, 800, 900a, 900b) to transport the nanostructured ferroelectric (300, 300a, 300b, 300c, 800, 900a, 900b) to a position associated with the predefined chirality.

10. The method according to claim 9, wherein the inhomogeneous electric field (506, 604, 604', 604") has a field polarization (508, 508'), and wherein the method further comprises selecting the field polarization (508, 508') according to the predefined chirality.

11. The method according to any of the preceding claims, wherein the applying the electromagnetic field (604, 604', 604") comprises applying a voltage (U, -U) to electrodes (602, 602', 602", 606) arranged on opposite sides of the nanostructured ferroelectric (300, 300a, 300b, 300c, 800, 900a, 900b).

12. The method according to claim 11, wherein at least one of the electrodes (602") has a chiral shape providing a chiral electromagnetic field (604") as the electromagnetic field (604").

13. The method according to any of the preceding claims, wherein providing the nanostructured ferroelectric (300, 300a, 300b, 300c, 800, 900a, 900b) in the high-temperature state comprises:
providing the nanostructured ferroelectric (300, 300a, 300b, 300c, 800, 900a, 900b) in the low-temperature ferroelectric state and with the first chirality (102R); and
heating the nanostructured ferroelectric (300, 300a, 300b, 300c, 800, 900a, 900b) to the high-temperature state;
wherein the predefined chirality is the second chirality (102L).

14. An apparatus for generating a nanostructured ferroelectric (300, 300a, 300b, 300c, 800, 900a, 900b) with a predefined chirality, the apparatus comprising:
a retaining element (302, 302') adapted to receive the nanostructured ferroelectric (300, 300a, 300b, 300c, 800, 900a, 900b);
a heating element (502, 504) adapted to heat the nanostructured ferroelectric (300, 300a, 300b, 300c, 800, 900a, 900b) to a high-temperature state;
a field application element (504, 602, 602', 602", 606) adapted to apply an electromagnetic field (506, 604, 604', 604") to the nanostructured ferroelectric (300, 300a, 300b, 300c, 800, 900a, 900b) while the nanostructured ferroelectric (300, 300a, 300b, 300c, 800, 900a, 900b) is in the high-temperature state;
wherein the field application element comprises electrodes arranged on opposite sides of the nanostructured ferroelectric, and at least one of the electrodes has a chiral shape, or
wherein the applying the electromagnetic field comprises irradiating the nanostructured ferroelectric with a circularly or elliptically polarized electromagnetic wave; and
a cooling element adapted to cool, while applying the electromagnetic field (506, 604, 604', 604") to the nanostructured ferroelectric (300, 300a, 300b, 300c, 800, 900a, 900b) using the field application element, the nanostructured ferroelectric (300, 300a, 300b, 300c, 800, 900a, 900b) to a low-temperature ferroelectric state with a polarization state with the predefined chirality.

15. The apparatus according to claim 14, further comprising:
a radiation source (504) adapted to generate an electromagnetic wave (506), and further adapted to irradiate the nanostructured ferroelectric (300, 300a, 300b, 300c, 800, 900a, 900b) with the electromagnetic wave (506);
in particular
wherein the radiation source (504) is comprised in optical tweezers adapted to transport the nanostructured ferroelectric to a position associated with the predefined chirality and/or to separate the nanostructured ferroelectric (300, 300a, 300b, 300c, 800, 900a, 900b) from a second nanostructured ferroelectric with a chirality different from the predefined chirality;
or wherein the radiation source (504) is comprised in plasmonic tweezers adapted to irradiate a conducting substrate of the nanostructured ferroelectric (300, 300a, 300b, 300c, 800, 900a, 900b) to induce plasmonic excitations in the conducting substrate to separate the nanostructured ferroelectric and a second nanostructured ferroelectric with a chirality different from the predefined chirality.

## Patentansprüche

1. Verfahren zum Erzeugen eines nanostrukturierten Ferroelektrikums (300, 300a, 300b, 300c, 800, 900a, 900b) mit einer vorab festgelegten Chiralität,
wobei das nanostrukturierte Ferroelektrikum (300, 300a, 300b, 300c, 800, 900a, 900b) dazu eingerichtet ist, einen Hochtemperaturzustand und einen Niedertemperatur ferroelektrischen Zustand bereitzustellen;
wobei in dem Niedertemperatur ferroelektrischen Zustand das nanostrukturierte Ferroelektrikum (300, 300a, 300b, 300c, 800, 900a, 900b) einen Polarisationszustand aus einer Mehrzahl von Polarisationszuständen hat;
wobei die Mehrzahl von Polarisationszuständen mindestens einen ersten chiralen Polarisationszustand mit einer ersten Chiralität (102R) und einen zweiten chiralen Polarisationszustand mit einer zweiten Chiralität (102L), die sich von der ersten Chiralität (102R) unterscheidet, aufweist;
wobei das Verfahren umfasst:
Auswählen der vorab festgelegten Chiralität aus der ersten Chiralität (102R) und der zweiten Chiralität (102L);
Auswählen eines elektromagnetischen Feldes (506, 604, 604', 604") gemäß der vorab festgelegten Chiralität;
Bereitstellen des nanostrukturierten Ferroelektrikums (300, 300a, 300b, 300c, 800, 900a, 900b) in dem Hochtemperaturzustand, wobei der Hochtemperaturzustand ein paraelektrischer Zustand ist oder ein ferroelektrischer Zustand bei einer erhöhten Temperatur ist, der sich von dem Niedertemperatur ferroelektrischen Zustand unterscheidet;
Anlegen des elektromagnetischen Feldes (506, 604, 604', 604") an das nanostrukturierte Ferroelektrikum (300, 300a, 300b, 300c, 800, 900a, 900b) in dem Hochtemperaturzustand; und
Kühlen, während des Anlegens des elektromagnetischen Feldes (506, 604, 604', 604"), des nanostrukturierten Ferroelektrikums (300, 300a, 300b, 300c, 800, 900a, 900b) von dem Hochtemperaturzustand in den Niedertemperatur ferroelektrischen Zustand, um den Polarisationszustand des nanostrukturierten Ferroelektrikums (300, 300a, 300b, 300c, 800, 900a, 900b) mit der vorab festgelegten Chiralität etablieren.

2. Verfahren nach Anspruch 1, wobei eine erste Ausdehnung des nanostrukturierten Ferroelektrikums (300, 300a, 300b, 300c, 800, 900a, 900b) entlang einer ersten Richtung höchstens 1000 nm, insbesondere höchstens 200 nm, höchstens 100 nm oder höchstens 80 nm beträgt.

3. Verfahren nach Anspruch 1 oder 2, wobei der Hochtemperaturzustand ein photoinduzierter angeregter Zustand und/oder ein strahlungsinduzierter angeregter Zustand ist.

4. Verfahren nach einem der vorhergehenden Ansprüche, wobei der Niedertemperaturzustand einem Raumtemperaturzustand des nanostrukturierten Ferroelektrikums (300, 300a, 300b, 300c, 800, 900a, 900b) entspricht.

5. Verfahren nach einem der vorhergehenden Ansprüche, wobei das Anlegen des elektromagnetischen Feldes (506) ein Bestrahlen des nanostrukturierten Ferroelektrikums (300, 300a, 300b, 300c, 800, 900a, 900b) mit einer elektromagnetischen Welle (506) aufweist.

6. Verfahren nach Anspruch 5, wobei die elektromagnetische Welle (506) elliptisch polarisiert ist; wobei insbesondere eine Chiralität (508) der elliptisch polarisierten elektromagnetischen Welle (506) der vorab festgelegten Chiralität entspricht.

7. Verfahren nach einem der vorhergehenden Ansprüche, das ferner ein Stützen des nanostrukturierten Ferroelektrikums (300, 300a, 300b, 300c, 800, 900a, 900b) durch ein Substrat (302) umfasst, insbesondere während des Anlegens des elektromagnetischen Feldes (506, 604, 604', 604").

8. Verfahren nach einem der vorhergehenden Ansprüche, wobei das nanostrukturierte Ferroelektrikum (300, 300a, 300b, 300c, 800, 900a, 900b) während des Kühlens des nanostrukturierten Ferroelektrikums (300, 300a, 300b, 300c, 800, 900a, 900b) von einer festen oder flüssigen Matrix (302') umgeben ist.

9. Verfahren nach einem der vorhergehenden Ansprüche, das ferner umfasst, während und/oder nach dem Kühlen des nanostrukturierten Ferroelektrikums (300, 300a, 300b, 300c, 800, 900a, 900b) von dem Hochtemperaturzustand in den Niedertemperatur ferroelektrischen Zustand:
Anlegen eines inhomogenen elektromagnetischen Feldes an das nanostrukturierte Ferroelektrikum (300, 300a, 300b, 300c, 800, 900a, 900b), um das nanostrukturierte Ferroelektrikum (300, 300a, 300b, 300c, 800, 900a, 900b) zu einer Position zu transportieren, die mit der vorab festgelegten Chiralität assoziiert ist.

10. Verfahren nach Anspruch 9, wobei das inhomogene elektrische Feld (506, 604, 604', 604") eine Feldpolarisation (508, 508') aufweist, und wobei das Verfahren ferner das Auswählen der Feldpolarisation (508, 508') gemäß der vorab festgelegten Chiralität umfasst.

11. Verfahren nach einem der vorhergehenden Ansprüche, wobei das Anlegen des elektromagnetischen Feldes (604, 604', 604") ein Anlegen einer Spannung (U, -U) an Elektroden (602, 602', 602", 606) umfasst, die an entgegengesetzten Seiten des nanostrukturierten Ferroelektrikums (300, 300a, 300b, 300c, 800, 900a, 900b) angeordnet sind.

12. Verfahren nach Anspruch 11, wobei zumindest eine der Elektroden (602") eine chirale Form aufweist, die ein chirales elektromagnetisches Feld (604") als das elektromagnetische Feld (604") bereitstellt.

13. Verfahren nach einem der vorhergehenden Ansprüche, wobei das Bereitstellen des nanostrukturierten Ferroelektrikums (300, 300a, 300b, 300c, 800, 900a, 900b) in dem Hochtemperaturzustand umfasst:
Bereitstellen des nanostrukturierten Ferroelektrikums (300, 300a, 300b, 300c, 800, 900a, 900b) in dem Niedertemperatur ferroelektrischen Zustand und mit der ersten Chiralität (102R); und
Erwärmen des nanostrukturierten Ferroelektrikums (300, 300a, 300b, 300c, 800, 900a, 900b) in den Hochtemperaturzustand;
wobei die vorab festgelegte Chiralität die zweite Chiralität (102L) ist.

14. Apparat zum Erzeugen eines nanostrukturierten Ferroelektrikums (300, 300a, 300b, 300c, 800, 900a, 900b) mit einer vorab festgelegten Chiralität, wobei der Apparat aufweist:
ein Halteelement (302, 302'), das dazu eingerichtet ist, das nanostrukturierte Ferroelektrikum (300, 300a, 300b, 300c, 800, 900a, 900b) aufzunehmen;
ein Erwärmungselement (502, 504), das dazu eingerichtet ist, das nanostrukturierte Ferroelektrikum (300, 300a, 300b, 300c, 800, 900a, 900b) in einen Hochtemperaturzustand zu erwärmen;
ein Feldanlegeelement (504, 602, 602', 602", 606), das dazu eingerichtet ist, ein elektromagnetisches Feld (506, 604, 604', 604") an das nanostrukturierte Ferroelektrikum (300, 300a, 300b, 300c, 800, 900a, 900b) anzulegen, während sich das nanostrukturierte Ferroelektrikum (300, 300a, 300b, 300c, 800, 900a, 900b) in dem Hochtemperaturzustand befindet;
wobei das Feldanlegeelement Elektroden aufweist, die an entgegengesetzten Seiten des nanostrukturierten Ferroelektrikums angeordnet sind, aufweist, und zumindest eine der Elektroden eine chirale Form hat, oder
wobei das Anlegen des elektromagnetischen Feldes ein Bestrahlen des nanostrukturierten Ferroelektrikums mit einer zirkular oder elliptisch polarisierten elektromagnetischen Welle umfasst; und
ein Kühlelement, das dazu eingerichtet ist, während des Anlegens des elektromagnetischen Feldes (506, 604, 604', 604") an das nanostrukturierte Ferroelektrikum (300, 300a, 300b, 300c, 800, 900a, 900b) unter Verwendung des Feldanlegeelements, das nanostrukturierte Ferroelektrikum (300, 300a, 300b, 300c, 800, 900a, 900b) in einen Niedertemperatur ferroelektrischen Zustand mit einem Polarisationszustand mit der vorab festgelegten Chiralität zu kühlen.

15. Apparat nach Anspruch 14, ferner aufweisend:
eine Strahlungsquelle (504), die dazu eingerichtet ist, eine elektromagnetische Welle (506) zu erzeugen, und ferner dazu eingerichtet ist, das nanostrukturierte Ferroelektrikum (300, 300a, 300b, 300c, 800, 900a, 900b) mit der elektromagnetischen Welle (506) zu bestrahlen;
insbesondere
wobei die Strahlungsquelle (504) in einer optischen Pinzette enthalten ist, die dazu eingerichtet ist, das nanostrukturierte Ferroelektrikum zu einer Position zu transportieren, die mit der vorab festgelegten Chiralität assoziiert ist, und/oder das nanostrukturierte Ferroelektrikum (300, 300a, 300b, 300c, 800, 900a, 900b) von einem zweiten nanostrukturierten Ferroelektrikum mit einer Chiralität zu trennen, die sich von der vorab festgelegten Chiralität unterscheidet;
oder wobei die Strahlungsquelle (504) in einer plasmonischen Pinzette enthalten ist, die dazu eingerichtet ist, ein leitfähiges Substrat des nanostrukturierten Ferroelektrikums (300, 300a, 300b, 300c, 800, 900a, 900b) zu bestrahlen, um plasmonische Anregungen in dem leitfähigen Substrat zu induzieren, um das nanostrukturierte Ferroelektrikum und ein zweites nanostrukturiertes Ferroelektrikum zu trennen, welches eine Chiralität hat, die sich von der vorab festgelegten Chiralität unterscheidet.

## Revendications

1. Procédé de génération d'un ferroélectrique nanostructuré (300, 300a, 300b, 300c, 800, 900a, 900b) avec une chiralité prédéfinie,
lequel ferroélectrique nanostructuré (300, 300a, 300b, 300c, 800, 900a, 900b) est adapté à fournir un état à haute température et un état ferroélectrique à basse température ;
lequel, dans l'état ferroélectrique à basse température, le ferroélectrique nanostructuré (300, 300a, 300b, 300c, 800, 900a, 900b) présente un état de polarisation parmi une pluralité d'états de polarisation ;
lequel la pluralité d'états de polarisation comprend au moins un premier état de polarisation chiral avec une première chiralité (102R) et un second état de polarisation chiral avec une seconde chiralité (102L) différente de la première chiralité (102R) ;
le procédé comprenant :
la sélection de la chiralité prédéfinie parmi la première chiralité (102R) et la seconde chiralité (102L) ;
la sélection d'un champ électromagnétique (506, 604, 604', 604") selon la chiralité prédéfinie ;
la fourniture du ferroélectrique nanostructuré (300, 300a, 300b, 300c, 800, 900a, 900b) dans l'état à haute température, lequel état à haute température est un état paraélectrique ou un état ferroélectrique différent de l'état ferroélectrique à basse température
à une température élevée ;
l'application du champ électromagnétique (506, 604, 604', 604") au ferroélectrique nanostructuré (300, 300a, 300b, 300c, 800, 900a, 900b) dans l'état à haute température ; et
le refroidissement, tout en appliquant le champ électromagnétique (506, 604, 604', 604"), du ferroélectrique nanostructuré (300, 300a, 300b, 300c, 800, 900a, 900b) de l'état à haute température vers l'état ferroélectrique à basse température afin d'établir l'état de polarisation du ferroélectrique nanostructuré (300, 300a, 300b, 300c, 800, 900a, 900b) avec la chiralité prédéfinie.

2. Procédé selon la revendication 1, dans lequel une première extension du ferroélectrique nanostructuré (300, 300a, 300b, 300c, 800, 900a, 900b) selon une première direction est au plus 1000 nm, en particulier au plus 200 nm, au plus 100 nm ou au plus 80 nm.

3. Procédé selon la revendication 1 ou 2, dans lequel l'état à haute température est un état excité photo-induit et/ou un état excité induit par irradiation.

4. Procédé selon l'une quelconque des revendications précédentes, dans lequel l'état à basse température correspond à un état à température ambiante du ferroélectrique nanostructuré (300, 300a, 300b, 300c, 800, 900a, 900b).

5. Procédé selon l'une quelconque des revendications précédentes, dans lequel l'application du champ électromagnétique (506) comprend l'irradiation du ferroélectrique nanostructuré (300, 300a, 300b, 300c, 800, 900a, 900b) avec une onde électromagnétique (506).

6. Procédé selon la revendication 5, dans lequel l'onde électromagnétique (506) est polarisée elliptiquement ; en particulier, dans lequel une chiralité (508) de l'onde électromagnétique polarisée elliptiquement (506) correspond à la chiralité prédéfinie.

7. Procédé selon l'une quelconque des revendications précédentes, comprenant en outre le support du ferroélectrique nanostructuré (300, 300a, 300b, 300c, 800, 900a, 900b) par un substrat (302), en particulier lors de l'application du champ électromagnétique (506, 604, 604', 604").

8. Procédé selon l'une quelconque des revendications précédentes, dans lequel le ferroélectrique nanostructuré (300, 300a, 300b, 300c, 800, 900a, 900b) est entouré d'une matrice solide ou liquide (302') lors du refroidissement du ferroélectrique nanostructuré (300, 300a, 300b, 300c, 800, 900a, 900b).

9. Procédé selon l'une quelconque des revendications précédentes, comprenant en outre, pendant et/ou après le refroidissement du ferroélectrique nanostructuré (300, 300a, 300b, 300c, 800, 900a, 900b) de l'état à haute température vers l'état ferroélectrique à basse température :
l'application d'un champ électromagnétique inhomogène au ferroélectrique nanostructuré (300, 300a, 300b, 300c, 800, 900a, 900b) pour transporter le ferroélectrique nanostructuré (300, 300a, 300b, 300c, 800, 900a, 900b) vers une position associée à la chiralité prédéfinie.

10. Procédé selon la revendication 9, dans lequel le champ électrique inhomogène (506, 604, 604', 604") présente une polarisation de champ (508, 508'), et dans lequel le procédé comprend en outre la sélection de la polarisation de champ (508, 508') selon la chiralité prédéfinie.

11. Procédé selon l'une quelconque des revendications précédentes, dans lequel l'application du champ électromagnétique (604, 604', 604") comprend l'application d'une tension (U, -U) à des électrodes (602, 602', 602", 606) qui sont disposées sur des côtés opposés du ferroélectrique nanostructuré (300, 300a, 300b, 300c, 800, 900a, 900b).

12. Procédé selon la revendication 11, dans lequel au moins l'une des électrodes (602") présente une forme chirale fournissant un champ électromagnétique chiral (604") en tant que champ électromagnétique (604").

13. Procédé selon l'une quelconque des revendications précédentes, dans lequel la fourniture du ferroélectrique nanostructuré (300, 300a, 300b, 300c, 800, 900a, 900b) dans l'état à haute température comprend :
la fourniture du ferroélectrique nanostructuré (300, 300a, 300b, 300c, 800, 900a, 900b) dans l'état ferroélectrique à basse température et avec la première chiralité (102R) ; et
le chauffage du ferroélectrique nanostructuré (300, 300a, 300b, 300c, 800, 900a, 900b) vers l'état à haute température ;
lequel la chiralité prédéfinie est la seconde chiralité (102L).

14. Appareil pour générer un ferroélectrique nanostructuré (300, 300a, 300b, 300c, 800, 900a, 900b) avec une chiralité prédéfinie, l'appareil comprenant :
un élément de maintien (302, 302') adapté à recevoir le ferroélectrique nanostructuré (300, 300a, 300b, 300c, 800, 900a, 900b) ;
un élément de chauffage (502, 504) adapté à chauffer le ferroélectrique nanostructuré (300, 300a, 300b, 300c, 800, 900a, 900b) vers un état à haute température ;
un élément d'application de champ (504, 602, 602', 602", 606) adapté à appliquer un champ électromagnétique (506, 604, 604', 604") au ferroélectrique nanostructuré (300, 300a, 300b, 300c, 800, 900a, 900b) pendant que le ferroélectrique nanostructuré (300, 300a, 300b, 300c, 800, 900a, 900b) est dans l'état à haute température ;
lequel l'élément d'application de champ comprend des électrodes qui sont disposées sur des côtés opposés du ferroélectrique nanostructuré, et au moins l'une des électrodes présente une forme chirale, ou
lequel l'application du champ électromagnétique comprend l'irradiation du ferroélectrique nanostructuré avec une onde électromagnétique polarisée circulairement ou elliptiquement ; et
un élément de refroidissement adapté à refroidir, tout en appliquant le champ électromagnétique (506, 604, 604', 604") au ferroélectrique nanostructuré (300, 300a, 300b, 300c, 800, 900a, 900b) à l'aide de l'élément d'application de champ, le ferroélectrique nanostructuré (300, 300a, 300b, 300c, 800, 900a, 900b) vers un état ferroélectrique à basse température avec un état de polarisation avec la chiralité prédéfinie.

15. Appareil selon la revendication 14, comprenant en outre :
une source de rayonnement (504) adaptée à générer une onde électromagnétique (506), et en outre adaptée à irradier le ferroélectrique nanostructuré (300, 300a, 300b, 300c, 800, 900a, 900b) avec l'onde électromagnétique (506) ;
en particulier
lequel la source de rayonnement (504) est comprise dans des pinces optiques adaptées à transporter le ferroélectrique nanostructuré vers une position associée à la chiralité prédéfinie et/ou à séparer le ferroélectrique nanostructuré (300, 300a, 300b, 300c, 800, 900a, 900b) d'un second ferroélectrique nanostructuré avec une chiralité différente de la chiralité prédéfinie ;
ou lequel la source de rayonnement (504) est comprise dans des pinces plasmoniques adaptées à irradier un substrat conducteur du ferroélectrique nanostructuré (300, 300a, 300b, 300c, 800, 900a, 900b) pour induire des excitations plasmoniques dans le substrat conducteur afin de séparer le ferroélectrique nanostructuré et un second ferroélectrique nanostructuré avec une chiralité différente de la chiralité prédéfinie.
